# DEMANDE DE BREVET EUROPEEN

(11) **EP 3 608 960 A1**
(43) Date de publication de la demande: **12.02.2020**
(21) Numéro de dépôt: 19189870.9
(22) Date de dépôt: 02.08.2019
(51) Int. Cl.: H01L 27/02, H02M 7/48, H03K 17/51, H03K 17/78

(54) **CIRCUIT DE COMMANDE DE BRAS D'ONDULEUR**

(30) Priorité: 06.08.2018 FR 1857326
(71) Demandeur: Commissariat à l'Energie Atomique et aux Energies Alternatives, 75015 Paris (FR)
(72) Inventeur: BUCKLEY, Julien, 38054 GRENOBLE Cedex 09 (FR); ESCOFFIER, René, 38054 GRENOBLE Cedex 9 (FR)
(74) Mandataire: Hautier, Nicolas

(57) **Abrégé**

L'invention a pour objet un circuit électronique 1 comprenant sur un même substrat un bras d'onduleur formé par des transistors « high side » 14 et « low side »15, et les circuits de commande de ces transistors 14, 15. Avantageusement, ces circuits de commande comprennent des portes logiques configurées pour recevoir un même signal d'entrée PWM et générer deux signaux de commande alternés à destination des transistors « high side » 14 et « low side »15. L'invention a également pour objet un système d'onduleur comprenant le circuit électronique 1 et des optocoupleurs laser configurés pour isoler électriquement le circuit 1 d'un contrôleur délivrant le signal d'entrée PWM et d'une alimentation principale alimentant électriquement les circuits de commande.

## Description

### DOMAINE TECHNIQUE DE L'INVENTION

L'invention concerne les circuits de commande et de contrôle pour les convertisseurs de puissance. Elle trouve au moins une application particulièrement avantageuse dans le domaine des onduleurs.

### ÉTAT DE LA TECHNIQUE

Un onduleur est un convertisseur de puissance notamment utilisé pour la conversion d'un courant continu DC (acronyme de « Direct Current ») en un courant alternatif AC (acronyme de « Alternating Current »).

Un tel onduleur comprend généralement un ou plusieurs bras d'onduleur et un ou plusieurs systèmes de commande du bras d'onduleur.

Le bras d'onduleur est formé par un interrupteur haut ou « High Side » selon la terminologie anglo-saxonne, et un interrupteur bas ou « Low Side » selon la terminologie anglo-saxonne, fonctionnant alternativement en configuration demi-pont de manière à générer le courant AC à partir du courant DC.

Pour la conversion d'une puissance élevée, il est avantageux d'utiliser des transistors de puissance pour former les interrupteurs « High Side » et « Low Side », par exemple des transistors à haute mobilité d'électrons HEMT (acronyme de « High Electron Mobility Transistor ») à base de GaN.

Le pilotage alternatif de ces transistors se fait par le système de commande.

Ce système de commande comprend généralement une électronique de pilotage et des circuits de commande dédiés à chacun des transistors « High Side » et « Low Side». Les circuits de commande sont couramment appelés « driver » ou « gate driver ». Ils reçoivent des signaux de pilotage issus de l'électronique de pilotage et délivrent des signaux de commande aux transistors. L'électronique de pilotage et les circuits de commande sont alimentés par une alimentation électrique.

Le système de commande est généralement externe au bras d'onduleur, pour des raisons de compatibilité technologique, d'encombrement et d'isolation électromagnétique vis-à-vis de l'environnement sévère de fonctionnement.

L'électronique de pilotage du bras d'onduleur est souvent basée sur une technologie CMOS (acronyme de « Complementary Metal Oxide Semiconductor »). Dans le cas d'un bras d'onduleur en particulier basé sur une technologie HEMT, une telle électronique de pilotage ne peut pas être directement intégrée au bras d'onduleur, du fait de l'absence de transistors complémentaire au HEMT ayant de bonnes performances (mobilité des trous).

Cette électronique de pilotage CMOS nécessite en outre une alimentation DC qui peut être encombrante.

Pour des raisons de sécurité de fonctionnement, le bras d'onduleur doit être isolé électriquement vis-à-vis des signaux de pilotage et de l'alimentation électrique du système de commande. Cette isolation se fait généralement au niveau des circuits de commande, par une isolation galvanique par exemple.

Cette isolation galvanique est également encombrante et difficilement intégrable.

Pour ces raisons, le système de commande est généralement assemblé dans un boîtier différent de celui du bras d'onduleur.

Un inconvénient de cette solution est que la fréquence maximale de fonctionnement de l'onduleur est limitée.

Un autre inconvénient de cette solution est une immunité limitée de l'onduleur face à un champ magnétique, typiquement pour un champ magnétique de 10 Gauss à 1 MHz.

Le document US 9831867 B1 divulgue une solution où le système de commande et le bras d'onduleur sont intégrés sur une même puce. Le circuit électronique en demi-pont de l'onduleur proposé est basé sur une technologie GaN. Ce circuit électronique comprend en particulier un bras d'onduleur et un système de commande fonctionnant avec des transistors à base de GaN.

Le système de commande du bras d'onduleur utilise des signaux de pilotage à modulation de largeur d'impulsion PWM (acronyme de « Pulse Width Modulation »). Un signal PWM_HS est envoyé en entrée du circuit de commande « High Side » commandant le transistor GaN « High Side » et un signal PWM_LS est envoyé en entrée du circuit de commande « Low Side » commandant le transistor GaN « Low Side ».

Le fonctionnement alterné des transistors « High Side » et « Low Side » est assuré par un générateur d'impulsion de suppression (« blanking pulse generator ») permettant d'introduire des temps morts et de garantir le non recouvrement des signaux de commande issus des signaux de pilotage PWM_HS et PWM_LS.

Un inconvénient de cette solution est que la fréquence maximale de fonctionnement de l'onduleur est intrinsèquement limitée.

Un objet de la présente invention est de pallier au moins en partie certains des inconvénients mentionnés ci-dessus.

Selon un aspect particulier, un objet de la présente invention est de proposer un circuit électronique d'onduleur simple et peu coûteux intégrant le système de commande et le bras d'onduleur sur une même puce.

Un autre objet de la présente invention est de proposer un circuit électronique d'onduleur visant à optimiser la fréquence maximale de fonctionnement de l'onduleur.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

Pour atteindre cet objectif, un premier aspect de l'invention concerne un circuit électronique comprenant un bras d'onduleur et un système de commande de ce bras d'onduleur formés au moins en partie sur un même substrat semiconducteur.

Le bras d'onduleur comprend un premier transistor de puissance de type transistor à haute mobilité d'électrons HEMT (acronyme signifiant « High Electron Mobility Transistor ») relié à un potentiel flottant et formant un transistor « high side » du bras d'onduleur, et un deuxième transistor de puissance de type HEMT relié à une masse et formant un transistor « low side » du bras d'onduleur.

Le système de commande du bras d'onduleur comprend un premier circuit de commande du transistor « high side » configuré pour délivrer un premier signal de commande au niveau d'une grille du transistor « high side » à partir d'un premier signal d'entrée reçu en entrée dudit premier circuit, et un deuxième circuit de commande du transistor « low side » configuré pour délivrer un deuxième signal de commande au niveau d'une grille du transistor « low side » à partir d'un deuxième signal d'entrée reçu en entrée dudit deuxième circuit.

Avantageusement mais non limitativement, les premier et deuxième signaux d'entrée sont synchrones et de préférence en phase et les premier et deuxième circuits de commande comprennent respectivement une première et une deuxième pluralités de portes logiques configurées pour délivrer les premier et deuxième signaux de commande sans recouvrement temporel à partir des premier et deuxième signaux d'entrée.

Selon l'invention et de façon particulièrement avantageuse, l'utilisation de signaux d'entrée synchrones permet d'avoir une référence temporelle identique pour les premier et deuxième circuits de commande. L'utilisation de signaux d'entrée en phase permet en outre de décaler temporellement ces signaux directement au niveau des premier et deuxième circuits de commande. Les première et deuxième pluralités de portes logiques permettent dès lors de générer des premier et deuxième signaux de commande présentant un décalage temporel relatif très précis. Ce décalage n'est pas dû à une électronique de pilotage externe ou préalable et peut ainsi être précisément contrôlé par les premier et deuxième circuits de commande. L'utilisation d'un seul et même signal d'entrée, dupliqué de façon à produire les premier et deuxième signaux d'entrée, est également rendue possible par l'invention. Ainsi, l'invention permet d'améliorer significativement la précision sur le décalage temporel obtenu et donc d'augmenter considérablement la fréquence de fonctionnement du circuit électronique, par exemple la fréquence de commutation d'un onduleur.

En outre la génération de ce décalage temporel au niveau de circuits de commande directement formés sur le même substrat semiconducteur que le bras d'onduleur permet de soustraire ce décalage temporel aux sources de parasites externes audit substrat. Cette solution supprime par exemple les inductances parasites rencontrées dans les configurations de circuit de commande externes au bras d'onduleur, et qui génèrent un retard non maîtrisé dans le décalage temporel.

Les première et deuxième pluralités de portes logiques formées sur le même substrat que le bras d'onduleur permettent ainsi de générer des premier et deuxième signaux de commande présentant un décalage temporel relatif minimisé.

Un tel décalage temporel permet d'assurer le non recouvrement des premier et deuxième signaux de commande tout en minimisant les temps morts entre ces signaux de commande.

La fréquence de fonctionnement de l'onduleur se trouve ainsi optimisée.

De façon avantageuse, l'intégration des circuits de commande sur le même substrat que les transistors du bras d'onduleur permet de réduire les délais de propagation entre les signaux d'entrée et de commande.

Une telle intégration permet également d'éloigner l'isolation électrique, par exemple galvanique, du bras d'onduleur. L'apparition à haute fréquence d'oscillations parasites dues à l'inductance de l'isolation galvanique est dès lors limitée voire supprimée.

La réduction des délais de propagation et la limitation des oscillations parasites améliorent le fonctionnement de l'onduleur à hautes fréquences.

Une telle intégration permet en outre de réduire considérablement l'encombrement de l'onduleur.

Selon un mode de réalisation préféré mais non limitatif, les première et deuxième pluralités de portes logiques comprennent uniquement des transistors dits transistors de porte et des résistances, et les transistors de porte sont formés sur le même substrat semiconducteur que les transistors « high side » et « low side ».

Cette architecture est simple et permet de minimiser les coûts de production.

Cette architecture permet en outre de s'affranchir avantageusement d'un temps caractéristique RC tel que celui du générateur d'impulsions de suppression divulgué dans le document US 9831867 B1.

Les temps morts liés à ce temps caractéristique RC sont dès lors avantageusement minimisés et la fréquence de fonctionnement de l'onduleur se trouve encore améliorée. Ainsi, l'invention offre des performances significativement améliorées notamment par rapport à la solution enseignée dans le document US 9831867 B1.

Un deuxième aspect de l'invention concerne un système d'onduleur comprenant un circuit électronique selon le premier aspect de l'invention, une première alimentation configurée pour alimenter le premier circuit de commande, une deuxième alimentation configurée pour alimenter le deuxième circuit de commande, et au moins un contrôleur configuré pour délivrer les premier et deuxième signaux d'entrée.

Le système d'onduleur comprend en outre de préférence un générateur de puissance en sortie du premier transistor « high side », ledit générateur étant commandé par le circuit électronique et configuré pour délivrer une puissance élevée.

Ce système d'onduleur permet de convertir un courant continu DC de puissance élevée en un courant alternatif AC de puissance élevée, de façon simple et peu coûteuse, et en bénéficiant d'une fréquence de fonctionnement optimisée.

Selon un mode de réalisation préféré mais non limitatif, le circuit électronique du système d'onduleur est isolé électriquement des première et deuxième alimentations et de l'au moins un contrôleur, par au moins un coupleur optique dit optocoupleur.

Cet optocoupleur comprend avantageusement au moins une matrice de diodes laser couplée avec au moins une matrice de cellules photovoltaïques en regard l'une de l'autre.

La matrice de diodes laser est configurée pour recevoir un signal électrique issu par exemple de l'une au moins parmi les première et deuxième alimentations, ou de l'au moins un contrôleur, et générer à partir dudit signal électrique un flux lumineux à destination d'au moins une matrice de cellules photovoltaïques.

La matrice de cellules photovoltaïques est configurée pour recevoir ce flux lumineux et pour délivrer subséquemment l'une au moins parmi les première et deuxième alimentations, ou l'un au moins parmi les premier et deuxième signaux d'entrée, en fonction de la provenance du signal électrique.

Un tel optocoupleur permet avantageusement de supprimer l'inductance parasite liée à une isolation galvanique.

L'utilisation de diodes laser permet en outre de délivrer un flux lumineux présentant une puissance suffisante pour transmettre les signaux électriques d'alimentation à l'au moins une matrice de cellules photovoltaïques. *In fine,* un tel optocoupleur peut donc alimenter électriquement les circuits de commande du bras d'onduleur.

Un tel optocoupleur présente également un encombrement limité et peut donc être facilement intégré dans le même boîtier que le circuit électronique.

L'invention proposée peut être avantageusement employée pour toute application nécessitant un onduleur. A titre d'exemples non limitatifs, le véhicule électrique peut être équipé d'au moins un des aspects de l'invention ; les alimentations à découpage (régulation de la tension de sortie, convertisseurs AC/AC, AC/DC, DC/DC, DC/AC) peuvent recourir à l'un au moins des aspects de l'invention ; la transmission de données numériques isolées ou le pilotage de charges sur secteur à partir d'un circuit accessible basse tension sont également d'autres applications pouvant bénéficier de l'un au moins des aspects de l'invention.

### BRÈVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
- La FIGURE 1A montre un schéma d'un circuit électronique selon un mode de réalisation de la présente invention ;
- La FIGURE 1B montre un schéma d'un système d'onduleur selon un mode de réalisation de la présente invention ;
- La FIGURE 1C montre un schéma d'un circuit électronique selon un autre mode de réalisation de la présente invention ;
- La FIGURE 2A montre des premier et deuxième signaux de commande obtenus par simulation à partir d'un circuit électronique selon un mode de réalisation de la présente invention ;
- La FIGURE 2B montre un signal électrique obtenu par simulation à partir d'un système d'onduleur selon un mode de réalisation de la présente invention ;
- Les FIGURES 3A et 3B illustrent respectivement un symbole logique et un schéma de réalisation physique d'une porte logique de type NON à un étage selon un mode de réalisation de la présente invention ;
- Les FIGURES 4A et 4B illustrent respectivement un symbole logique et un schéma de réalisation physique d'une porte logique de type NON à deux étages selon un mode de réalisation de la présente invention ;
- Les FIGURES 5A et 5B illustrent respectivement un symbole logique et un schéma de réalisation physique d'une porte logique de type ET selon un mode de réalisation de la présente invention ;
- Les FIGURES 6A et 6B illustrent respectivement un symbole logique et un schéma de réalisation physique d'une porte logique à fonction retard selon un mode de réalisation de la présente invention ;
- Les FIGURES 7A et 7B illustrent un circuit électronique isolé électriquement par un optocoupleur intégrés dans un même boîtier selon un mode de réalisation de la présente invention, respectivement en vue de dessus et en coupe transverse selon le plan A-A indiqué à la FIGURE 7A ;
- La FIGURE 7C illustre en coupe transverse un circuit électronique isolé électriquement par un optocoupleur intégrés dans un même boîtier selon un autre mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques.

En particulier, les épaisseurs et dimensions des différentes couches et portions des dispositifs illustrés ne sont pas représentatives de la réalité.

Certains choix de représentations schématiques peuvent combiner des symboles normalisés, par exemple américain ou européen, avec d'autres symboles librement exécutés et explicités en référence à la description.

### DESCRIPTION DÉTAILLÉE DE L'INVENTION

Avant d'entamer une revue détaillée de modes de réalisation de l'invention, il est rappelé que l'invention selon son premier aspect comprend notamment les caractéristiques optionnelles ci-après pouvant être utilisées en association ou alternativement :
- Selon un mode de réalisation, les transistors de porte des première et deuxième pluralités de portes logiques sont uniquement des transistors à effet de champ à canal de type N.
- Selon un mode de réalisation, la première pluralité de portes logiques comprend au moins :
   ∘ une première porte logique à fonction retard configurée pour retarder le premier signal d'entrée, et
   ∘ une première porte logique de type ET comprenant deux entrées recevant respectivement le premier signal d'entrée et le premier signal d'entrée retardé,
   et la deuxième pluralité de portes logiques comprend au moins :
   ∘ une deuxième porte logique à fonction retard configurée pour retarder le deuxième signal d'entrée, et
   ∘ une porte logique de type NON configurée pour inverser le deuxième signal d'entrée retardé, et une autre porte logique de type NON configurée pour inverser le deuxième signal d'entrée
   ∘ une deuxième porte logique de type ET comprenant deux entrées recevant respectivement le deuxième signal d'entrée inversé et le deuxième signal d'entrée retardé et inversé.

Cette architecture permet de retarder précisément les premier et deuxième signaux de commande l'un relativement à l'autre. Cette architecture permet également d'alterner les valeurs que prennent les premier et deuxième signaux de commande respectivement entre une première valeur haute et une première valeur basse, et entre une deuxième valeur haute et une deuxième valeur basse. Cette architecture permet donc de générer des signaux de commande « high side » et « low side » présentant à la fois une alternance temporelle et une alternance de valeur.
- Selon un mode de réalisation, les portes logiques de type NON à un étage comprennent chacune un seul transistor de porte présentant une largeur de grille (généralement nommée Wg dans la littérature) comprise entre 0.5 mm et 2 mm.
- Selon un mode de réalisation, les portes logiques de type NON à un étage sont identiques entre elles.
- Selon un mode de réalisation, la première pluralité de portes logiques comprend en outre :
   ∘ une première porte logique de type NON configurée pour inverser un signal issu de la première porte logique de type ET, et délivrer le premier signal de commande à la grille du premier transistor « high side » sans chute de potentiel de ce premier signal de commande pour une intensité de courant de ce premier signal de commande comprise entre 500mA et 5A.
   et la deuxième pluralité de portes logiques comprend en outre :
   ∘ une deuxième porte logique de type NON configurée pour inverser un signal issu de la deuxième porte logique de type ET, et délivrer le deuxième signal de commande à la grille du deuxième transistor « low side », sans chute de potentiel de ce deuxième signal de commande pour une intensité de courant de ce deuxième signal de commande comprise entre 500mA et 5A.

Les première et deuxième portes logiques assurent ainsi leurs fonctions logiques inverseur pour une large gamme de courant. Cela permet d'obtenir en particulier une commande également viable pour des courants et des puissances élevées.
- Selon un mode de réalisation, les première et deuxième portes logiques de type NON sont dites à deux étages et comprennent chacune un premier étage formé par une porte logique de type NON à un étage et un deuxième étage relié au premier étage et comprenant deux transistors de porte fonctionnant en opposition de phase et présentant chacun une largeur de grille comprise entre 5 mm et 50 mm et de préférence entre 5 mm et 20 mm.

De tels transistors fonctionnant en opposition de phase permettent de relayer la fonction logique inverseur des portes logiques de type NON à un étage, tout en offrant une résistance d'accès élevée au niveau de leurs grilles. Ces résistances d'accès élevées permettent de maintenir les potentiels des premier et deuxième signaux de commande à des valeurs nominales.
- Selon un mode de réalisation, les transistors de porte du deuxième étage présentent des résistances d'accès au niveau de leurs grilles supérieures à 1MegaOhm, et de préférence supérieures à 1GigaOhm.
- Selon un mode de réalisation, les premier et deuxième signaux d'entrée sont des signaux à modulation de largeur d'impulsion PWM (acronyme signifiant « pulse width modulation »).
- Selon un mode de réalisation, le substrat semiconducteur, les premier et deuxième transistors « high side » et « low side », et les transistors de porte des première et deuxième pluralités de portes logiques sont à base de GaN.

L'invention selon son deuxième aspect comprend notamment les caractéristiques optionnelles ci-après pouvant être utilisées en association ou alternativement :
- Selon un mode de réalisation, le système d'onduleur comprend en outre un générateur de puissance en sortie du premier transistor « high side », ledit générateur étant configuré pour délivrer un signal électrique Vout pouvant présenter une puissance élevée.
- Selon un mode de réalisation, le substrat semiconducteur, une source du deuxième transistor « low side » et le générateur de puissance sont reliés à une masse commune.

La connexion du générateur et de la source du deuxième transistor « low side » à cette masse commune permet d'assurer une référence pour le signal électrique Vout.

La connexion du substrat semiconducteur à cette même masse empêche ledit substrat d'être flottant. Cela permet de limiter les signaux parasites et les piégeages de charges au niveau de chacun des transistors des première et deuxième pluralités de portes logiques et des premier et deuxième transistors « high side » et « low side ». Cela permet également d'éviter un effet de substrat auto polarisé préjudiciable à la polarisation de grille des transistors.
- Selon un mode de réalisation, le circuit électronique est isolé électriquement de l'au moins un contrôleur, par au moins un coupleur optique dit optocoupleur comprenant une matrice de diodes laser et au moins une matrice de cellules photovoltaïques en regard, ladite matrice de diodes laser étant configurée pour recevoir un signal électrique issu de l'au moins un contrôleur, et générer en fonction dudit signal électrique un flux lumineux à destination de l'au moins une matrice de cellules photovoltaïques, ladite au moins une matrice de cellules photovoltaïques étant configurée pour recevoir le flux lumineux et pour délivrer l'un au moins parmi les premier et deuxième signaux d'entrée.
- Selon un mode de réalisation, le circuit électronique est isolé électriquement de l'une au moins parmi les première et deuxième alimentations, par au moins un coupleur optique dit optocoupleur comprenant une matrice de diodes laser et au moins une matrice de cellules photovoltaïques en regard, ladite matrice de diodes laser étant configurée pour recevoir un signal électrique issu de l'une au moins parmi les première et deuxième alimentations, et générer en fonction dudit signal électrique un flux lumineux à destination de l'au moins une matrice de cellules photovoltaïques, ladite au moins une matrice de cellules photovoltaïques étant configurée pour recevoir le flux lumineux et pour délivrer l'une au moins parmi les première et deuxième alimentations.
- Selon un mode de réalisation, le circuit électronique et l'au moins un optocoupleur sont assemblés dans un même boîtier.
- Selon un mode de réalisation, les première et deuxième alimentations sont une même alimentation dite alimentation principale.
- Selon un mode de réalisation, l'au moins un contrôleur est un unique contrôleur dit contrôleur principal.
- Selon un mode de réalisation, l'alimentation principale est isolée électriquement du circuit électronique par un premier optocoupleur comprenant une matrice de diodes laser reliée à ladite alimentation principale, une première matrice de cellules photovoltaïques reliée au premier circuit de commande et une deuxième matrice de cellules photovoltaïques reliée au deuxième circuit de commande, lesdites première et deuxième matrices de cellules photovoltaïques étant couplées avec et tournées en regard de ladite matrice de diodes laser du premier optocoupleur, lesdites première et deuxième matrices de cellules photovoltaïques étant configurées pour alimenter respectivement les premier et deuxième circuits de commande.
- Selon un mode de réalisation, le contrôleur principal est isolé électriquement du circuit électronique par un deuxième optocoupleur comprenant une matrice de diodes laser reliée audit contrôleur principal, une première matrice de cellules photovoltaïques reliée au premier circuit de commande et une deuxième matrice de cellules photovoltaïques reliée au deuxième circuit de commande, lesdites première et deuxième matrices de cellules photovoltaïques étant couplées avec et tournées en regard de ladite matrice de diodes laser du deuxième optocoupleur, lesdites première et deuxième matrices de cellules photovoltaïques étant configurées pour délivrer respectivement les premier et deuxième signaux d'entrée aux premier et deuxième circuits de commande.

Dans la présente invention, on entend par « transistors de type HEMT » des transistors à effet de champ à haute mobilité d'électrons, parfois également désignés par le terme de transistor à effet de champ à hétérostructure. Un tel transistor inclut la superposition de deux couches semi-conductrices ayant des bandes interdites différentes qui forment un puit quantique à leur interface. Des électrons sont confinés dans ce puits quantique pour former un gaz bidimensionnel d'électrons. Pour des raisons de tenue en haute tension et en température, ces transistors sont choisis de façon à présenter une large bande d'énergie interdite.

Parmi les transistors HEMT à large bande d'énergie interdite, les transistors à base de nitrure de gallium sont très prometteurs. Leur largeur de bande d'énergie interdite (>3eV) induit un champ électrique critique plus élevé comparé aux matériaux classiques de l'électronique, une vitesse de saturation élevée des porteurs et de bonnes stabilités thermique et chimique. Le champ de claquage du nitrure de gallium peut ainsi être supérieur à 2x10⁶ V/cm, ce qui permet aisément de réaliser des transistors compacts avec des tensions de claquage supérieures à 600 V. Avec un transistor à conduction latérale, la tension de claquage grille/drain peut aisément être contrôlée par une distance appropriée entre grille et drain. Une tension de claquage de l'ordre de 600 V peut ainsi être atteinte pour une distance entre la grille et le drain du transistor de l'ordre de quelques microns (4 à 10 µm par exemple). De plus, de tels transistors permettent de très grandes densités de courant du fait de la très grande mobilité électronique et de la forte densité électronique dans le gaz d'électrons d'interface.

Il est précisé que, dans le cadre de la présente invention, le dépôt d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

Il est précisé que, dans le cadre de la présente invention, la disposition relative d'une troisième couche intercalée entre une première couche et une deuxième couche, ne signifie pas obligatoirement que les couches sont directement au contact les unes des autres, mais signifie que la troisième couche est soit directement au contact des première et deuxième couches, soit séparée de celles-ci par au moins une autre couche ou au moins un autre élément. Par exemple et de façon connue en soi dans le domaine des transistors de type HEMT à base de GaN, une fine couche en AIN peut être intercalée entre deux couches semi-conductrices en GaN et en AIGaN.

On entend par un substrat, un dispositif, une couche, « à base » d'un matériau A, un substrat, un dispositif, une couche comprenant ce matériau A uniquement ou ce matériau A et éventuellement d'autres matériaux, par exemple des éléments d'alliage, des impuretés ou des éléments dopants, le matériau A présentant des propriétés avantageuses pour le substrat, le dispositif, ou la couche. Ainsi, un transistor à base de nitrure de gallium (GaN) comprend une partie active en GaN, avec éventuellement des portions dopées ou en alliage AIGaN par exemple.

Dans la présente invention, on entend par « transistors de type NMOS » des transistors à effet de champ dans lesquels les porteurs majoritaires sont des électrons ; ils présentent en particulier un canal de type N apte à faire passer un courant d'électrons.

Différentes architectures de transistors peuvent être utilisées, par exemple mais de façon non limitative : le MOSFET (acronyme anglais de « Métal Oxide Semiconductor Field Effect Transistor ») où la grille métallique est isolée du canal, le MESFET (acronyme anglais de « Metal Semiconductor FET ») où la grille métallique est directement au contact du canal, le HFET (acronyme anglais de « Heterostructure FET ») où un semiconducteur grand gap est intercalé entre la grille et le canal, le MODFET (acronyme anglais de « Modulation Doped FET ») où les dopants sont essentiellement situés dans le semiconducteur grand gap tandis que les électrons issus de ces dopants transitent essentiellement dans le canal.

Généralement, si la grille du transistor NMOS est mise à une tension supérieure à une tension seuil, la source et le drain sont connectés par le canal et le transistor est dit passant. Si la grille du transistor NMOS est mise à une tension inférieure à la tension seuil, la source et le drain ne sont plus connectés et le transistor est dit bloqué.

Dans la suite, le maintien d'une valeur nominale, par exemple une valeur de tension supérieure à la tension de seuil, signifie que cette valeur ne présente pas de variations significatives dans le temps pendant lequel elle est maintenue. Par exemple, pour des transistors configurés pour recevoir en entrée un signal dont la tension est comprise entre 0V et 5V, le maintien de la valeur nominale de tension à l'état passant signifie que cette valeur reste strictement supérieure à 2V. Le maintien de la valeur nominale de tension à l'état bloquant signifie que cette valeur reste strictement inférieure à 0,2V.

Les électrons circulent entre la source et le drain selon la longueur du canal.

La dimension en largeur du canal peut être dimensionnée en fonction de l'intensité du courant d'électrons que l'on souhaite faire passer par le transistor.

Dans la suite, on entend par « développement » d'un transistor la dimension en largeur de la grille. Par exemple, un transistor de développement 10 mm présente une grille de largeur 10 mm, le canal pouvant présenter par exemple une longueur comprise entre 250nm et 2 µm.

Sur les figures, les notations suivantes sont utilisées : G pour grille, S pour source, D pour drain.

Les convertisseurs de puissance ont pour fonction de convertir un signal électrique (une première source) en un autre signal électrique (une deuxième source). Il existe par exemple des convertisseurs destinés à convertir un courant alternatif en un autre courant alternatif (convertisseurs AC/AC), des convertisseurs destinés à convertir un courant continu en un autre courant continu (convertisseurs DC/DC), des convertisseurs destinés à convertir un courant alternatif en un courant continu (convertisseurs AC/DC dits redresseurs), et des convertisseurs destinés à convertir un courant continu en un courant alternatif (convertisseurs DC/AC dits onduleurs).

Un onduleur est donc connecté d'une part à une source de tension continue et d'autre part à une ou plusieurs charges résistives ou inductives. Ces connexions se font au niveau d'un bras d'onduleur. Un onduleur peut être constitué d'un ou plusieurs bras.

Le bras d'onduleur peut être constitué par une ou plusieurs cellules de commutation.

Chaque cellule de commutation est formée d'une paire d'interrupteurs haut et bas reliés entre eux. Par le jeu de la commutation de ces interrupteurs, l'onduleur modifie périodiquement l'interconnexion de la source de tension et de la charge.

La cellule de commutation doit respecter les règles fondamentales d'interconnexion des sources suivantes :
Une source de tension ne doit pas être court-circuitée mais elle peut être ouverte.

Une source de courant ne doit pas être ouverte mais elle peut être court-circuitée.

Il faut donc que l'état des deux interrupteurs de la cellule de commutation soit complémentaire, c'est-à-dire que lorsque l'interrupteur haut est bloqué, l'interrupteur bas est passant et inversement.

Pour assurer cette commutation complémentaire, les interrupteurs haut et bas sont commandés par des signaux de commande séparés temporellement.

Un ou des circuits de commande peuvent être en particulier conçus de sorte à générer des signaux de commande sans recouvrement temporel.

Un circuit de commande est un assemblage de constituants physiques branchés ou reliés les uns aux autres de telle sorte qu'il puisse se commander, se diriger ou se régler lui-même, ou bien commander, diriger ou régler un autre système tel qu'un système d'onduleur.

Ces circuits de commande peuvent par exemple introduire des temps morts entre les signaux de commande de chaque interrupteur de la cellule de commutation.

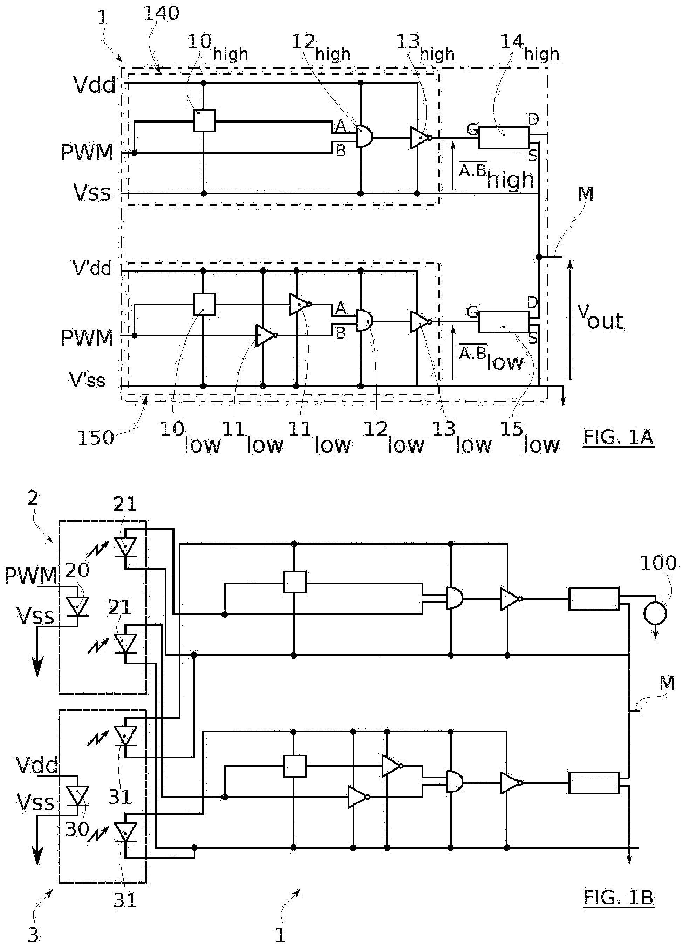

Selon l'invention, un premier mode de réalisation du circuit électronique comprenant les circuits de commande d'un bras d'onduleur va maintenant être décrit en référence à la figure 1A.

Le circuit électronique 1 comprend un bras d'onduleur formé par une paire d'interrupteurs haut et bas, et des circuits de commande de ces interrupteurs. L'interrupteur haut est formé par un premier transistor « high side » 14 dont la source est à un potentiel flottant.

Ce transistor « high side » 14 est de préférence un transistor HEMT, par exemple à base de GaN ou d'AsGa. Ce transistor « high side » 14 peut présenter un développement de 300 mm, de façon à fonctionner avec un courant de l'ordre de 30A. En particulier, ce transistor « high side » 14 est configuré pour supporter une charge haute tension présentant une tension par exemple supérieure à 400V, et de préférence supérieure à 600V, par exemple pour une distance grille/drain supérieure ou égale à 10µm.

L'interrupteur bas est formé par un deuxième transistor « low side » 15 dont la source est à la masse.

Ce transistor « low side » 15 peut également présenter un développement de 300 mm, de façon à supporter également un courant de charge de l'ordre de 30A et une haute tension présentant une tension par exemple supérieure à 400V, et de préférence supérieure à 600V.

Les transistors « high side » 14 et « low side » 15 peuvent présenter une tension de seuil comprise entre 1.5V et 4V ajustable selon les besoins.

Les transistors « high side » 14 et « low side » 15 sont reliés entre eux de façon à former un circuit en demi-pont.

En particulier, la source du transistor « high side » 14 est connectée au drain du transistor « low side » 15, et le drain du transistor « low side » 15 présente une connexion de sortie au niveau d'un point milieu M.

Le bras d'onduleur présente ainsi une sortie à point milieu M permettant d'alimenter une charge en courant alternatif.

Le transistor « high side » 14 est commandé par un premier circuit de commande 140 comprenant une première pluralité de portes logiques 10, 12, 13.

Le transistor « low side » 15 est commandé par un deuxième circuit de commande 150 comprenant une deuxième pluralité de portes logiques 10, 11, 12, 13.

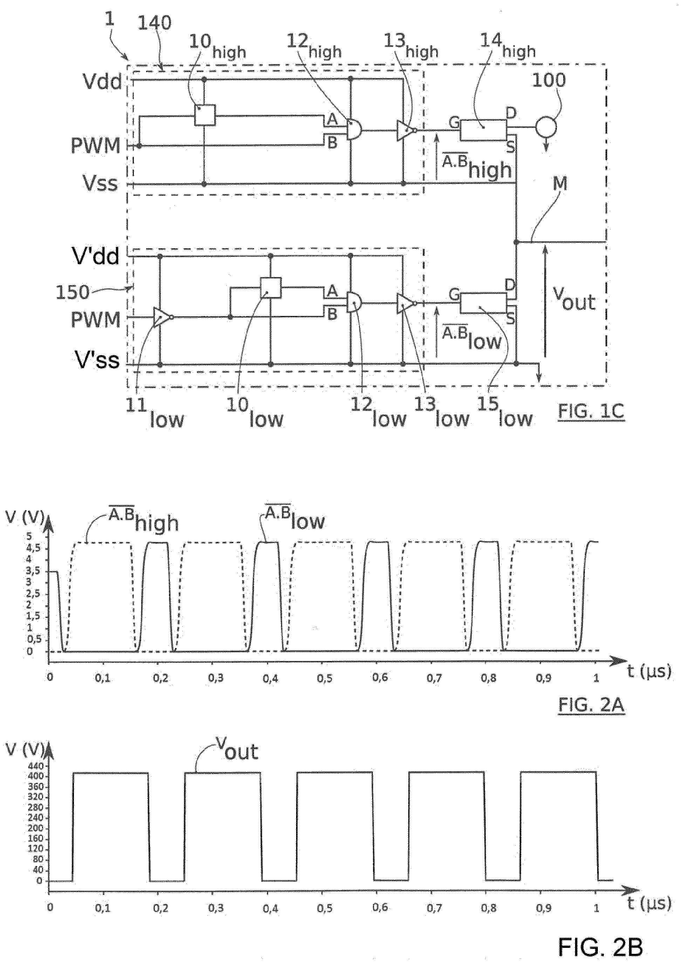

Le premier circuit de commande 140 peut être configuré pour délivrer à la grille du transistor « high side » 14 un premier signal de commande *̅A̅*̅ ·̅ *B̅_{high}* tel qu'illustré à la figure 2A.

Ce premier signal de commande présente une tension pouvant varier entre une valeur basse inférieure à la tension de seuil du transistor « high side » 14, par exemple sensiblement égale à 0V, et une valeur haute supérieure à la tension de seuil du transistor « high side » 14, par exemple comprise entre 4,5V et 5V. Cette tension du premier signal de commande est égale à la différence de potentiel entre le potentiel de grille du transistor « high side » 14 et le potentiel flottant.

Le deuxième circuit de commande 150 peut être configuré pour délivrer à la grille du transistor « low side » 15 un deuxième signal de commande *̅A̅*̅ ·̅ *B̅_{low}* tel qu'illustré à la figure 2A.

Ce deuxième signal de commande peut varier entre une valeur basse inférieure à la tension de seuil du transistor « low side » 15, par exemple sensiblement égale à 0V, et une valeur haute supérieure à la tension de seuil du transistor « low side » 15, par exemple comprise entre 4,5V et 5V.

Cette tension du deuxième signal de commande est égale à la différence de potentiel entre le potentiel de grille du transistor « low side » 15 et la masse du circuit 1.

Les premier et deuxième signaux de commande sont alternés temporellement de façon à ce que la valeur haute du premier signal de commande corresponde temporellement à la valeur basse du deuxième signal de commande, et de façon à ce que la valeur haute du deuxième signal de commande corresponde temporellement à la valeur basse du premier signal de commande.

En particulier, les premier et deuxième circuits de commande 140, 150 sont configurés de sorte à ce que les premier et deuxième signaux de commande ne présentent jamais leurs valeurs hautes respectives simultanément. Les transistors « high side » 14 et « low side » 15 ne sont dès lors jamais à l'état passant simultanément.

Les premier et deuxième signaux de commande peuvent présenter leurs valeurs basses respectives simultanément. Les transistors « high side » 14 et « low side » 15 peuvent dès lors être à l'état bloquant simultanément.

Le bras d'onduleur peut être configuré pour délivrer au niveau de la sortie à point milieu M un signal de sortie tel qu'illustré à la figure 2B.

Ce signal de sortie peut présenter une tension alternative variant entre 0V et une tension crête supérieure ou égale à 400V par exemple, ou supérieure ou égale à 600V. Le signal de sortie peut présenter une forme en créneau ou sensiblement sinusoïdale.

Pour obtenir une forme sinusoïdale du signal de sortie, les signaux de commande des transistors « high side » 14 et « low side » 15 sont de préférence modulés en largeur d'impulsion par les circuits de commande respectifs.

Ces circuits de commande 140, 150 peuvent notamment recevoir en entrée des signaux d'entrée à modulation de largeur d'impulsion, notés PWM, de la part d'un ou plusieurs contrôleurs.

Les circuits de commande peuvent notamment recevoir des signaux d'entrée PWM synchrones.

Selon une possibilité avantageuse, les premier et deuxième circuits de commande reçoivent chacun un signal d'entrée PWM temporellement identique.

Ce signal d'entrée PWM est dès lors traité par les première et deuxième pluralités de portes logiques de façon à obtenir les premier et deuxième signaux de commande décrits ci-dessus.

Avantageusement, les première et deuxième pluralités de portes logiques comprennent des transistors NMOS fonctionnant uniquement avec des électrons. Ce fonctionnement est compatible avec le fonctionnement d'un transistor HEMT.

Les premier et deuxième circuits de commande 140, 150 peuvent dès lors être intégrés sur une même puce et sur un même substrat semiconducteur que les transistors « high side » 14 et « low side » 15.

En particulier, le canal des transistors NMOS et le canal des transistors HEMT « high side » 14 et « low side » 15 peuvent être formés dans une même couche semiconductrice du substrat semiconducteur.

Le substrat semiconducteur comprend de préférence une couche semiconductrice à base de GaN.

La formation des transistors NMOS et la formation des transistors HEMT « high side » 14 et « low side » 15 peuvent avantageusement partager une majorité d'étapes technologiques communes.

Cette compatibilité de construction permet de simplifier la fabrication du circuit électronique 1.

Cela permet en outre de réduire les coûts de fabrication du circuit électronique 1.

Par ailleurs, un tel circuit électronique 1 associant ces premier et deuxième circuits de commande 140, 150 aux transistors HEMT « high side » 14 et « low side » 15 et fonctionnant uniquement avec des électrons présente un fonctionnement optimisé. En particulier, la rapidité de commutation des transistors « high side » 14 et « low side » 15 peut être optimisée.

La première pluralité de portes logiques comprend de préférence une première porte logique à fonction retard 10 _{high}, une première porte logique de type ET 12 _{high} et une première porte logique de type NON 13 _{high}.

La première porte à fonction retard 10 _{high} reçoit de préférence en entrée le signal d'entrée PWM et délivre en sortie un premier signal PWM retardé.

La première porte de type ET 12 _{high} reçoit de préférence sur une entrée A le signal d'entrée PWM et sur une entrée B le premier signal PWM retardé issu de la première porte à fonction retard 10 _{high}, et délivre en sortie un signal *A* . *B_{high}.*

La première porte de type NON 13 _{high} reçoit de préférence en entrée le signal *A* · *B_{high}* issu de la première porte de type ET 12 _{high}, et délivre en sortie un signal *A̅ ·̅ B̅_{high}* correspondant au premier signal de commande.

La deuxième pluralité de portes logiques comprend de préférence une deuxième porte logique à fonction retard 10 _{low}, deux portes logiques de type NON 11 _{low}, une deuxième porte logique de type ET 12 _{low} et une deuxième porte logique de type NON 13_{low}.

La deuxième porte à fonction retard 10 _{low} reçoit de préférence en entrée le signal d'entrée PWM et délivre en sortie un deuxième signal PWM retardé.

L'une parmi les deux portes de type NON 11 _{low} reçoit de préférence en entrée le signal d'entrée PWM et délivre en sortie un signal d'entrée PWM inversé.

L'autre parmi les deux portes de type NON 11 _{low} reçoit de préférence en entrée le deuxième signal PWM retardé et délivre en sortie un signal PWM retardé inversé.

La deuxième porte de type ET 12 _{low} reçoit de préférence sur une entrée A le signal d'entrée PWM inversé issu de l'une parmi les deux portes de type NON 11 _{low} et sur une entrée B le signal PWM retardé inversé issu de l'autre parmi les deux portes de type NON 11 _{low}, et délivre en sortie un signal *A* · *B_{low}.*

La deuxième porte de type NON 13 _{low} reçoit de préférence en entrée le signal *A* · *B_{low}* issu de la deuxième porte de type ET 12 _{low}, et délivre en sortie un signal *̅A̅*̅ ·̅ *B̅_{low}* correspondant au deuxième signal de commande.

Selon ce mode de réalisation, le signal d'entrée PWM est distribué sur deux branches correspondant aux entrées A et B de la deuxième porte de type ET 12 _{low}, traité puis inversé sur chacune des branches avant d'être délivré auxdites entrées A et B.

Selon un mode de réalisation alternatif illustré à la figure 1C, la deuxième pluralité de portes logiques comprend une deuxième porte logique à fonction retard 10 _{low}, une seule porte logique de type NON 11 _{low}, une deuxième porte logique de type ET 12 _{low} et une deuxième porte logique de type NON 13 _{low}.

La porte de type NON 11 _{low} reçoit de préférence en entrée le signal d'entrée PWM et délivre en sortie un signal d'entrée PWM inversé.

La deuxième porte à fonction retard 10 _{low} reçoit de préférence en entrée le signal d'entrée PWM inversé et délivre en sortie un signal PWM inversé retardé.

La deuxième porte de type ET 12 _{low} reçoit de préférence sur une entrée A le signal d'entrée PWM inversé issu de la porte de type NON 11 _{low} et sur une entrée B le signal PWM inversé retardé issu de la deuxième porte à fonction retard 10 _{low}, et délivre en sortie un signal *A* · *B_{low}.*

La deuxième porte de type NON 13 _{low} reçoit de préférence en entrée le signal *A* · *B_{low}* issu de la deuxième porte de type ET 12 _{low}, et délivre en sortie un signal *̅A̅*̅ ·̅ *B̅_{low}* correspondant au deuxième signal de commande.

Selon ce mode de réalisation, le signal d'entrée PWM est d'abord inversé, puis distribué et traité sur deux branches correspondant aux entrées A et B de la deuxième porte de type ET 12 _{low}. Cette opération ne nécessite qu'une seule porte logique de type NON 11 _{low}. Selon cette possibilité, la complexité et le coût associés à la réalisation de la deuxième pluralité de portes logiques sont réduits par rapport au mode de réalisation décrit précédemment.

Les deux portes logiques de type NON 11 _{low} comprennent de préférence un seul transistor NMOS associé à une résistance R1.

Le transistor NMOS est de préférence un transistor à base de GaN de développement 1 mm.

La résistance R1 peut présenter une valeur comprise entre 500 Ohm et 2000 Ohm par exemple.

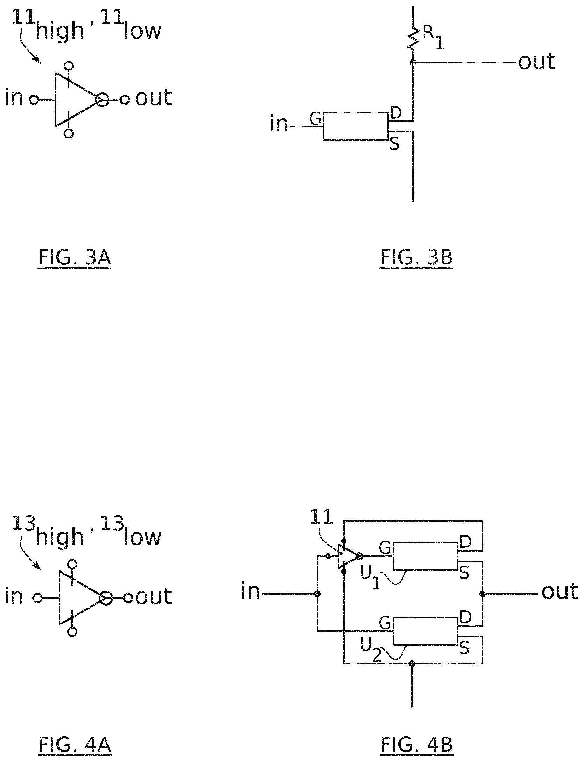

Un symbole logique et une architecture de ces portes logiques de type NON 11 _{low} sont illustrés aux figures 3A et 3B respectivement.

Ces deux portes logiques de type NON 11 _{low} sont identiques et la description ci-après de l'une de ces portes logiques est valable pour l'autre porte logique.

L'entrée d'une telle porte logique est connectée à la grille du transistor NMOS.

Le drain du transistor NMOS est connecté à la résistance.

La sortie de la porte logique est située entre le drain et la résistance.

Cette porte logique peut être alimentée électriquement par une source d'alimentation aux potentiels V'dd et V'ss.

En particulier, la source du transistor est de préférence reliée à V'ss, et la résistance est de préférence reliée à V'dd par un côté opposé au côté connecté au drain.

Une telle architecture est dénommée dans la suite « porte logique de type NON à un étage 11 ».

Cette architecture constitue de préférence une brique de base du circuit électronique 1.

Les première et deuxième portes logiques de type NON 13 _{high}, 13 _{low} comprennent de préférence chacune un premier étage formé par une porte logique de type NON à un étage 11 et un deuxième étage comprenant deux transistors NMOS U1, U2.

Ces première et deuxième portes logiques de type NON 13 _{high}, 13 _{low} sont configurées pour charger les grilles respectives des transistors « high side » 14 et « low side » 15. Les deux transistors NMOS U1, U2 sont de préférence des transistors à base de GaN de développement 10 mm.

Un tel développement permet notamment de faire passer dans ces transistors un courant d'intensité plus grande que celui passant dans le transistor NMOS du premier étage.

Ces transistors NMOS U1, U2 peuvent présenter vis-à-vis des transistors « high side » 14 et « low side » 15 un rapport de développement supérieur à 20 et de préférence supérieur ou égal à 30.

Ce dimensionnement peut permettre aux transistors NMOS U1, U2 et aux transistors « high side » 14 et « low side » 15 de fonctionner de façon optimisée chacun dans leur gamme de fonctionnement.

Un symbole logique et une architecture de ces première et deuxième portes logiques de type NON 13 _{high}, 13 _{low} sont illustrés aux figures 4A et 4B respectivement.

La description ci-après de l'une de ces portes logiques est valable pour l'autre porte logique.

L'entrée d'une telle porte logique est connectée d'une part à l'entrée de la porte logique de type NON à un étage 11 du premier étage, et d'autre part à la grille du transistor U2. La grille du transistor U1 est connectée à la sortie de la porte logique de type NON à un étage 11 du premier étage.

Le drain du transistor U2 est directement connecté à la source du transistor U1.

La sortie de cette porte logique est située entre le drain et la source directement connectés de ces deux transistors U2, U1.

Avantageusement, la résistance d'accès à la grille du transistor U1 est supérieure à la résistance R1 du premier étage. Cela permet de faire passer dans les transistors U1, U2 un courant d'intensité plus grande que celui passant dans le transistor NMOS du premier étage, sans chute de potentiel significative au niveau de la sortie de cette porte logique. Cette porte logique permet donc avantageusement de maintenir une valeur de tension nominale en sortie, par exemple supérieure à la tension de seuil du transistor « high side » 14 ou du transistor « low side » 15, même pour des courants de forte intensité. En particulier, les transistors U1, U2 peuvent délivrer et maintenir une tension de 5V sous un courant de 1A.

Cette porte logique peut être alimentée électriquement par une source d'alimentation aux potentiels Vdd et Vss (ou V'dd et V'ss).

En particulier, la source du transistor U2 est de préférence reliée à Vss (ou V'ss) et le drain du transistor U1 est de préférence relié à Vdd (ou V'dd).

La source d'alimentation alimente également la porte logique de type NON à un étage du premier étage.

Une telle architecture est dénommée dans la suite « porte logique de type NON à deux étages ».

Les deux portes logiques de type NON 13 _{high}, 13 _{low} peuvent être identiques, ou dimensionnées en fonction des transistors « high side » 14 et « low side » 15.

Par exemple, pour des transistors « high side » 14 et « low side » 15 présentant un rapport de développement sensiblement égal à 30, les transistors U1, U2 de la première porte logique de type NON 13 _{high} peuvent présenter un développement supérieur d'un facteur sensiblement égal à 30 au développement des transistors U1, U2 de la deuxième porte logique de type NON 13 _{low}.

Les première et deuxième portes logiques de type ET 12 _{high}, 12 _{low} comprennent de préférence chacune deux transistors NMOS et une résistance.

Les deux transistors NMOS T1, T2 sont de préférence des transistors à base de GaN de développement 1 mm.

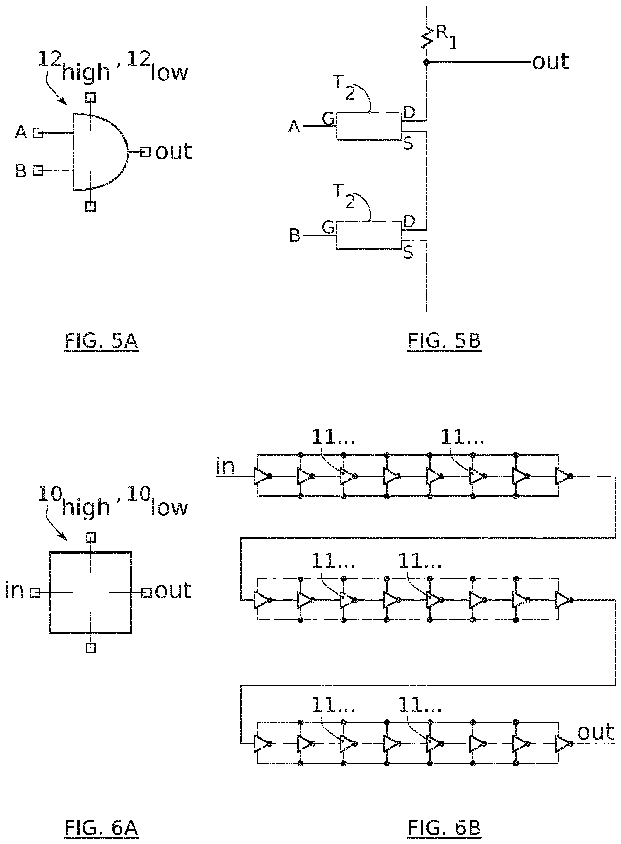

Un symbole logique et une architecture de ces première et deuxième portes logiques de type ET 12 _{high}, 12 _{low} sont illustrés aux figures 5A et 5B respectivement.

Ces deux portes logiques de type ET 12 _{high}, 12 _{low} peuvent être identiques et la description ci-après de l'une de ces portes logiques est valable pour l'autre porte logique.

Une telle porte logique présente deux entrées A et B.

L'entrée A d'une telle porte logique est de préférence connectée à la grille du transistor T1.

L'entrée B d'une telle porte logique est de préférence connectée à la grille du transistor T2.

Le drain du transistor T2 est directement connecté à la source du transistor T1.

Le drain du transistor T1 est connecté à la résistance R1.

La sortie de la porte logique est située entre le drain du transistor T1 et la résistance R1.

Cette porte logique peut être alimentée électriquement par une source d'alimentation aux potentiels Vdd et Vss (ou V'dd et V'ss).

En particulier, la source du transistor T2 est de préférence reliée à Vss (ou V'ss), et la résistance R1 est de préférence reliée à Vdd (ou V'dd) par un côté opposé au côté connecté au drain du transistor T1.

Les première et deuxième portes logiques à fonction retard 10 _{high}, 10 _{low} comprennent de préférence chacune une pluralité de portes logiques de type NON à un étage 11.

Un schéma logique et une architecture de ces première et deuxième portes logiques à fonction retard 10 _{high}, 10 _{low} sont illustrés aux figures 6A et 6B respectivement.

La description ci-après de l'une de ces portes logiques est valable pour l'autre porte logique.

L'entrée d'une telle porte logique reçoit un signal PWM. Elle correspond à l'entrée d'une porte logique de type NON à un étage 11.

La sortie d'une telle porte logique délivre un signal PWM retardé. Elle correspond à la sortie d'une autre porte logique de type NON à un étage 11.

Une telle porte logique à fonction retard comprend, entre son entrée et sa sortie, un nombre pair de portes logiques de type NON à un étage 11 associées en série.

Le signal PWM en entrée subit en effet un retard élémentaire et une inversion à chaque passage d'une porte logique de type NON à un étage 11.

L'association en série d'un nombre pair de portes logiques de type NON à un étage 11 permet dès lors de neutraliser deux à deux les inversions de signal et de cumuler les retards élémentaires de sorte à obtenir en sortie de la porte logique à fonction retard un signal PWM retardé présentant un retard total égal à la somme des retards élémentaires.

Les première et deuxième portes à fonction retard 10 _{high} et 10 _{low} comprennent respectivement des premier et deuxième nombres de portes logiques de type NON à un étage 11 différents.

Ces premier et deuxième nombres dépendent par exemple de la fréquence maximale de commutation visée pour les premier et deuxième circuits de commande. En particulier, la fréquence maximale de commutation peut être de l'ordre de 10MHz.

En particulier et avantageusement, les première et deuxième portes à fonction retard 10 _{high} et 10 _{low} sont configurées pour délivrer respectivement des premier et deuxième signaux PWM retardés présentant un décalage temporel entre eux suffisant pour assurer le non recouvrement, et minimal pour minimiser les temps morts de commutation et augmenter la fréquence de commutation.

Ce décalage temporel correspond à la différence des retards totaux obtenus respectivement en sortie des première et deuxième portes à fonction retard 10 _{high} et 10 _{low}.

Selon une possibilité avantageuse, les première et deuxième pluralités de portes logiques sont alimentées électriquement par une même source d'alimentation, nommée alimentation principale dans la suite.

Un deuxième aspect de l'invention concerne un système d'onduleur.

Selon un mode de réalisation préféré mais non limitatif, ce système peut comprendre, tel qu'illustré à la figure 1B, un circuit électronique 1 alimenté électriquement par une alimentation principale aux potentiels Vdd et Vss, et contrôlé par un contrôleur délivrant un signal d'entrée PWM.

Ce système d'onduleur comprend en outre de préférence un générateur de puissance 100 connecté au drain du transistor « high side » 14. Ce système d'onduleur permet dès lors de convertir un courant continu DC de puissance élevée en un courant alternatif AC de puissance élevée.

De façon avantageuse, le circuit électronique 1 du système d'onduleur est isolé électriquement du contrôleur et de l'alimentation principale.

Un premier optocoupleur 2 isole de préférence le circuit électronique 1 du contrôleur.

Un deuxième optocoupleur 3 isole de préférence le circuit électronique 1 de l'alimentation principale.

Ces premier et deuxième optocoupleurs 2, 3 exploitent de préférence un même principe d'isolation.

Ils peuvent néanmoins être dimensionnés différemment en fonction par exemple de la puissance des signaux électriques à transmettre.

Ce principe d'isolation est le suivant :
Une entrée d'un tel optocoupleur recevant le signal électrique est reliée à une matrice de diodes laser. Cette matrice de diode laser convertit le signal électrique d'entrée en signal lumineux. Le signal lumineux est émis à destination d'une matrice de cellules photovoltaïques. Une telle matrice de cellules photovoltaïques peut être par exemple réalisée selon le procédé de fabrication divulgué dans le document FR 3012669 A1. Cette matrice de cellules photovoltaïques reçoit le signal lumineux et le convertit en signal électrique, afin d'alimenter le circuit électronique 1.

Les premier et deuxième optocoupleurs 2, 3 comprennent de préférence respectivement chacun une matrice de diodes laser 20, 30 couplée avec une ou plusieurs matrices de cellules photovoltaïques 21, 31 en regard.

En particulier, le premier optocoupleur 2 peut être dimensionné comme suit :
Avantageusement, une matrice de diodes laser 20 est reliée au contrôleur, et tournée en regard de deux matrices de cellules photovoltaïques 21. La matrice de diodes laser 20 et les matrices de cellules photovoltaïques 21 peuvent être séparées par une couche diélectrique 200, par exemple en SiO2. L'une des deux matrices de cellules photovoltaïques 21 est reliée au premier circuit de commande afin de délivrer sensiblement le signal d'entrée PWM issu du contrôleur.

L'autre matrice de cellules photovoltaïques 21 est reliée au deuxième circuit de commande afin de délivrer sensiblement le signal d'entrée PWM issu du contrôleur.

Chacune des matrices de cellules photovoltaïques 21 peut comprendre un nombre de cellules élémentaires qui soit fonction de la tension du signal d'entrée PWM.

Par exemple, pour des cellules élémentaires délivrant environ 0,3 V sous une puissance lumineuse de 750 µW environ, chacune des matrices de cellules photovoltaïques 21 peut comprendre 16 cellules élémentaires de façon à délivrer au total 16 X 0,3 V = 4,8 V en entrée des premier et deuxième circuits de commande.

Le deuxième optocoupleur 3 peut être dimensionné comme suit :
Avantageusement, une matrice de diodes laser 30 est reliée l'alimentation principale, et tournée en regard de deux matrices de cellules photovoltaïques 31.

La matrice de diodes laser 30 et les matrices de cellules photovoltaïques 31 peuvent être séparées par une couche diélectrique 300, par exemple en SiO2.

L'une des deux matrices de cellules photovoltaïques 31 est reliée au premier circuit de commande afin de délivrer une première alimentation électrique issue de l'alimentation principale.

L'autre matrice de cellules photovoltaïques 31 est reliée au deuxième circuit de commande afin de délivrer une deuxième alimentation électrique issue de l'alimentation principale.

Chacune des matrices de cellules photovoltaïques 31 peut comprendre un nombre de cellules élémentaires qui soit fonction de la tension d'alimentation nécessaire aux première et deuxième alimentations électriques des premier et deuxième circuits de commande respectivement.

Par exemple, pour des cellules élémentaires délivrant environ 0,4 V sous une puissance lumineuse de 4 W environ, chacune des matrices de cellules photovoltaïques 21 peut comprendre 81 cellules élémentaires de façon à délivrer au total 81 X 0,4 V = 32,4 V en entrée des premier et deuxième circuits de commande.

Une telle architecture associant deux matrices de cellules photovoltaïques 21, 31 à une matrice de diodes laser 20, 30 permet avantageusement de dédoubler le signal d'entrée PWM et/ou le signal d'alimentation principale.

Cette architecture permet en outre d'obtenir une intégration des composants du système d'onduleur optimisée.

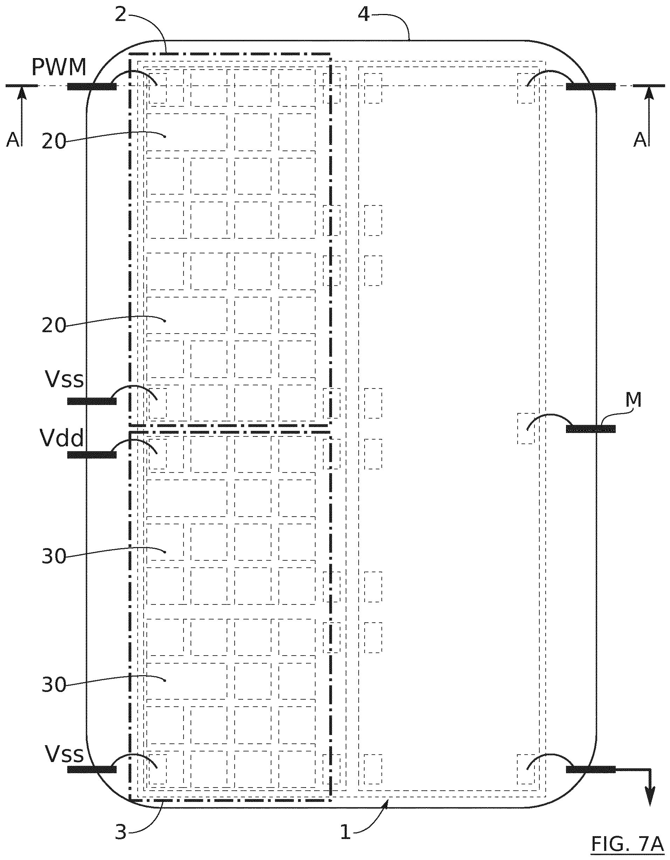

Tel qu'illustré aux figures 7A-7C, il est ainsi possible d'intégrer dans un même boîtier 4 le circuit électronique 1 et les premier et deuxième optocoupleurs 2, 3.

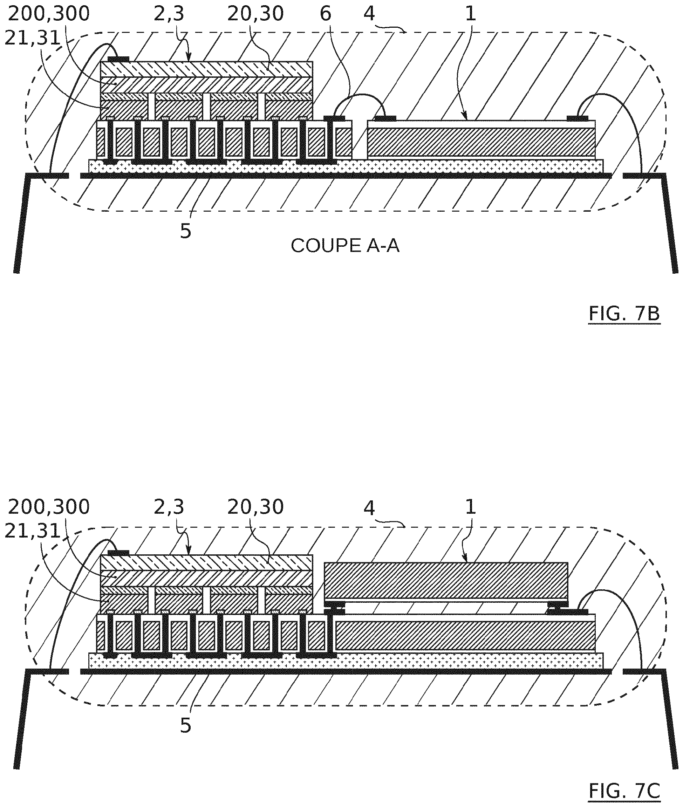

Par exemple, les premier et deuxième optocoupleurs 2, 3 peuvent être fabriqués et/ou assemblés sur une première puce et collés ou soudés sur une grille de connexion 5, et le circuit électronique 1 peut être fabriqué sur une deuxième puce collée ou soudée sur la grille de connexion 5 à proximité des premier et deuxième optocoupleurs 2, 3 (figure 7B). Des fils de connexion 6 peuvent ensuite permettre de connecter les premier et deuxième optocoupleurs 2, 3 au circuit électronique 1. Le boîtier 4 entourant la grille de connexion 5, les premier et deuxième optocoupleurs 2, 3 et le circuit électronique 1 peut être plein, de type époxy, ou à cavité (pour favoriser la dissipation thermique du convertisseur de puissance par exemple).

Selon un autre exemple, les premier et deuxième optocoupleurs 2, 3 peuvent être fabriqués et/ou assemblés sur une première puce collée ou soudée sur une grille de connexion 5, et le circuit électronique 1 peut être retourné et reporté sur cette première puce. La connexion entre les premier et deuxième optocoupleurs 2, 3 et le circuit électronique 1 peut dès lors se faire au niveau de plots de connexion (figure 7C).

L'invention n'est pas limitée aux modes de réalisations précédemment décrits et s'étend à tous les modes de réalisation couverts par les revendications.

## Revendications

1. Circuit électronique (1) comprenant un bras d'onduleur et un système de commande de ce bras d'onduleur formés au moins en partie sur un même substrat semiconducteur, le bras d'onduleur comprenant un premier transistor de puissance de type transistor à haute mobilité d'électrons HEMT (acronyme signifiant « High Electron Mobility Transistor ») relié à un potentiel flottant et formant un transistor « high side » (14) du bras d'onduleur, et un deuxième transistor de puissance de type HEMT relié à une masse et formant un transistor « low side » (15) du bras d'onduleur, le système de commande du bras d'onduleur comprenant un premier circuit de commande du transistor « high side » configuré pour délivrer un premier signal de commande au niveau d'une grille du transistor « high side » à partir d'un premier signal d'entrée reçu en entrée dudit premier circuit, et un deuxième circuit de commande du transistor « low side » configuré pour délivrer un deuxième signal de commande au niveau d'une grille du transistor « low side » à partir d'un deuxième signal d'entrée reçu en entrée dudit deuxième circuit, ledit circuit électronique (1) étant **caractérisé en ce que** les premier et deuxième signaux d'entrée sont synchrones et en phase, et **en ce que** les premier et deuxième circuits de commande comprennent respectivement une première et une deuxième pluralités de portes logiques configurées pour délivrer les premier et deuxième signaux de commande sans recouvrement temporel à partir des premier et deuxième signaux d'entrée.

2. Circuit (1) selon la revendication précédente dans lequel les première et deuxième pluralités de portes logiques comprennent uniquement des résistances et des transistors dits transistors de porte, les transistors de porte étant formés sur le même substrat semiconducteur que les transistors « high side » (14) et « low side » (15).

3. Circuit (1) selon la revendication précédente dans lequel les transistors de porte des première et deuxième pluralités de portes logiques sont uniquement des transistors à effet de champ à canal de type N.

4. Circuit (1) selon l'une quelconque des revendications précédentes dans lequel la première pluralité de portes logiques comprend au moins :
- une première porte logique à fonction retard (10_{high}) configurée pour retarder le premier signal d'entrée, et
- une première porte logique de type ET (12_{high}) comprenant deux entrées recevant respectivement le premier signal d'entrée et le premier signal d'entrée retardé,
et dans lequel la deuxième pluralité de portes logiques comprend au moins :
- une deuxième porte logique à fonction retard (10_{low}) configurée pour retarder le deuxième signal d'entrée, et
- une porte logique de type NON (11_{low}) configurée pour inverser le deuxième signal d'entrée retardé, et une autre porte logique de type NON (11_{low}) configurée pour inverser le deuxième signal d'entrée.
- une deuxième porte logique de type ET (12_{low}) comprenant deux entrées recevant respectivement le deuxième signal d'entrée inversé et le deuxième signal d'entrée retardé et inversé.

5. Circuit (1) selon la revendication précédente dans lequel les portes logiques de type NON (11_{low}) sont dites à un étage et comprennent chacune un seul transistor de porte présentant une largeur de grille comprise entre 0.5 mm et 2 mm, et dans lequel lesdites portes logiques (11_{low}) sont identiques entre elles.

6. Circuit (1) selon l'une quelconque des deux revendications précédentes dans lequel la première pluralité de portes logiques comprend en outre :
- une première porte logique de type NON (13_{high}) configurée pour inverser un signal issu de la première porte logique de type ET, et délivrer le premier signal de commande à la grille du premier transistor « high side » sans chute de potentiel de ce premier signal de commande pour une intensité de courant de ce premier signal de commande comprise entre 500mA et 5A,
et dans lequel la deuxième pluralité de portes logiques comprend en outre :
- une deuxième porte logique de type NON (13_{low}) configurée pour inverser un signal issu de la deuxième porte logique de type ET, et délivrer le deuxième signal de commande à la grille du deuxième transistor « low side », sans chute de potentiel de ce deuxième signal de commande pour une intensité de courant de ce deuxième signal de commande comprise entre 500mA et 5A.

7. Circuit (1) selon les deux revendications précédentes dans lequel les première et deuxième portes logiques de type NON (13_{high, low}) sont dites à deux étages et comprennent chacune un premier étage formé par une porte logique de type NON (11) à un étage et un deuxième étage relié au premier étage, le deuxième étage comprenant deux transistors de porte fonctionnant en opposition de phase et présentant chacun une longueur de grille comprise entre 5 mm et 50mm et de préférence entre 5 mm et.20 mm.

8. Circuit (1) selon la revendication précédente dans lequel les transistors de porte du deuxième étage présentent des résistances d'accès au niveau de leurs grilles supérieures à 1MegaOhm, et de préférence supérieures à 1GigaOhm.

9. Circuit (1) selon l'une quelconque des revendications précédentes dans lequel les premier et deuxième signaux d'entrée sont des signaux à modulation de largeur d'impulsion PWM (acronyme signifiant « Pulse Width Modulation »).

10. Système d'onduleur comprenant un circuit électronique (1) selon l'une quelconque des revendications précédentes, une première alimentation configurée pour alimenter le premier circuit de commande, une deuxième alimentation configurée pour alimenter le deuxième circuit de commande, et au moins un contrôleur configuré pour délivrer les premier et deuxième signaux d'entrée.

11. Système selon la revendication précédente dans lequel le substrat semiconducteur, une source du deuxième transistor « low side » (15) et le générateur de puissance (100) sont reliés à une masse commune.

12. Système selon l'une quelconque des deux revendications précédentes dans lequel le circuit électronique (1) est isolé électriquement de l'au moins un contrôleur, par au moins un coupleur optique dit optocoupleur (2) comprenant une matrice de diodes laser (20) et au moins une matrice de cellules photovoltaïques (21) en regard de la matrice de diodes laser (20), ladite matrice de diodes laser (20) étant configurée pour recevoir un signal électrique issu de l'au moins un contrôleur, et générer en fonction dudit signal électrique un flux lumineux à destination de l'au moins une matrice de cellules photovoltaïques (21), ladite au moins une matrice de cellules photovoltaïques (21) étant configurée pour recevoir le flux lumineux et pour délivrer l'un au moins parmi les premier et deuxième signaux d'entrée.

13. Système selon l'une quelconque des trois revendications précédentes dans lequel le circuit électronique (1) est isolé électriquement de l'une au moins parmi les première et deuxième alimentations, par au moins un coupleur optique dit optocoupleur (3) comprenant une matrice de diodes laser (30) et au moins une matrice de cellules photovoltaïques (31) en regard de la matrice de diodes laser (20), ladite matrice de diodes laser (30) étant configurée pour recevoir un signal électrique issu de l'une au moins parmi les première et deuxième alimentations, et générer en fonction dudit signal électrique un flux lumineux à destination de l'au moins une matrice de cellules photovoltaïques (31), ladite au moins une matrice de cellules photovoltaïques (31) étant configurée pour recevoir le flux lumineux et pour délivrer l'une au moins parmi les première et deuxième alimentations.

14. Système selon l'une quelconque des deux revendications précédentes dans lequel le circuit électronique (1) et l'au moins un optocoupleur (2, 3) sont assemblés dans un même boîtier (4).

15. Système selon les revendications 13 et 14 dans lequel les première et deuxième alimentations sont une même alimentation dite alimentation principale et l'au moins un contrôleur est un unique contrôleur dit contrôleur principal, et dans lequel l'alimentation principale est isolée électriquement du circuit électronique (1) par un premier optocoupleur (3) comprenant une matrice de diodes laser (30) reliée à ladite alimentation principale, une première matrice de cellules photovoltaïques (31) reliée au premier circuit de commande et une deuxième matrice de cellules photovoltaïques (31) reliée au deuxième circuit de commande, lesdites première et deuxième matrices de cellules photovoltaïques (31) étant couplées avec et tournées en regard de ladite matrice de diodes laser (30) du premier optocoupleur (3), lesdites première et deuxième matrices de cellules photovoltaïques (31) étant configurées pour alimenter respectivement les premier et deuxième circuits de commande, et dans lequel le contrôleur principal est isolé électriquement du circuit électronique (1) par un deuxième optocoupleur (2) comprenant une matrice de diodes laser (20) reliée audit contrôleur principal, une première matrice de cellules photovoltaïques (21) reliée au premier circuit de commande et une deuxième matrice de cellules photovoltaïques (21) reliée au deuxième circuit de commande, lesdites première et deuxième matrices de cellules photovoltaïques (21) étant couplées avec et tournées en regard de ladite matrice de diodes laser (20) du deuxième optocoupleur (2), lesdites première et deuxième matrices de cellules photovoltaïques (21) étant configurées pour délivrer respectivement les premier et deuxième signaux d'entrée aux premier et deuxième circuits de commande.
